# EUROPEAN PATENT APPLICATION

(11) **EP 4 057 784 A1**
(43) Date of publication of application: **14.09.2022**
(21) Application number: 20884642.8
(22) Date of filing: 22.05.2020
(51) Int. Cl.: H05K 3/46

(54) **MULTILAYER WIRING BOARD**

(30) Priority: 08.11.2019 JP 2019202914
(71) Applicant: NGK SPARK PLUG CO., LTD., Mizuho-ku Nagoya-shi Aichi 4678525 (JP)
(72) Inventor: HASHIMOTO Hirohito, Nagoya-shi, Aichi 4678525 (JP); NASU Takakuni, Nagoya-shi, Aichi 4678525 (JP); SHIRAKI Fumio, Nagoya-shi, Aichi 4678525 (JP); JIN Guangzhu, Nagoya-shi, Aichi 4678525 (JP)
(74) Representative: Cabinet Beau de Loménie
(86) International application number: PCT/JP2020/020311
(87) International publication number: WO 2021/090527

(57) **Abstract**

To make a ceramic substrate that is used for a multilayer wiring substrate reusable.

A multilayer wiring substrate includes a first wiring substrate including a plurality of stacked layers made of a thermosetting resin and having a wiring layer formed between each adjacent layers of the layers in a state in contact with the adjacent layers; a second wiring substrate made of a ceramic; and a joining layer disposed between a back surface of the first wiring substrate and a front surface of the second wiring substrate and configured to join the first wiring substrate and the second wiring substrate to each other. At least a surface of the joining layer adjacent to the second wiring substrate is made of a thermoplastic resin.

## Description

### Technical Field

The present invention relates to a multilayer wiring substrate.

### Background Art

There is known a multilayer wiring substrate in which a resin substrate including a plurality of stacked resin layers and a ceramic substrate having a connecting terminal are collectively stacked (for example, see PTL 1). In the multilayer wiring substrate described in PTL 1, the plurality of resin layers are individually fabricated, and then the resin substrate and the ceramic substrate are collectively stacked. A wiring substrate described in PTL 2 includes a joining layer that joins a front surface of a ceramic substrate and a back surface of a wiring layer to each other. The joining layer has a core layer made of a thermosetting resin and an adhesive layer made of a thermosetting resin having a lower elasticity than that of the core layer.

### Citation List

### Patent Literature

PTL 1: Japanese Unexamined Patent Application Publication No. 2017-37929
PTL 2: International Publication No. 2013/031822

### Summary of Invention

### Technical Problem

The number of man-hours for manufacturing a ceramic that is used for a multilayer wiring substrate is larger than the number of man-hours for manufacturing other components. Thus, the number of man-hours for manufacturing the entire multilayer wiring substrate may increase, and the time required for manufacturing the multilayer wiring substrate may increase. PTL 1 and PTL 2 disclose a method of manufacturing each layer in the multilayer wiring substrate; however, PTL 1 and PTL 2 do not consider the numbers of man-hours for manufacturing the multilayer wiring substrate and the ceramic. To decrease the number of man-hours for manufacturing the multilayer wiring substrate, there has been a demand of reusing the ceramic that takes many man-hours for manufacturing.

The present invention is made to solve the above-described problem and an object of the invention is to provide a ceramic substrate that is used for a multilayer wiring substrate and that is reusable.

### Solution to Problem

The present invention is made to solve the above-described problem, and can be implemented as aspects as follows.

(1) According to an aspect of the present invention, a multilayer wiring substrate is provided. The multilayer wiring substrate includes a first wiring substrate including a plurality of stacked layers made of a thermosetting resin and having a wiring layer formed between each adjacent layers of the layers in a state in contact with the adjacent layers; a second wiring substrate made of a ceramic; and a joining layer disposed between a back surface of the first wiring substrate and a front surface of the second wiring substrate and configured to join the first wiring substrate and the second wiring substrate to each other. At least a surface of the joining layer adjacent to the second wiring substrate is made of a thermoplastic resin.
   With the configuration, the surface, which is adjacent to the front surface of the second wiring substrate, of the joining layer configured to join the back surface of the first wiring substrate and the front surface of the second wiring substrate to each other is made of the thermoplastic resin. Thus, even after the first wiring substrate and the second wiring substrate are joined to each other, when heat is applied to the multilayer wiring substrate, the thermoplastic resin changes, and the joining between the first wiring substrate and the second wiring substrate is released. In contrast, the joining between the layers of the first wiring substrate joined by the thermosetting resin is not released. As the results, the first wiring substrate and the second wiring substrate can be easily separated from each other, and the first wiring substrate and the second wiring substrate can be reused. Thus, reusing the second wiring substrate that takes many man-hours for manufacturing can decrease the number of man-hours for manufacturing the multilayer wiring substrate. Also, fabricating in advance a ceramic applicable to many multilayer wiring substrates decreases the number of man-hours for manufacturing the multilayer wiring substrate.
(2) In the multilayer wiring substrate of the above-described aspect, a connecting terminal may be formed on each of front surfaces and back surfaces of the first wiring substrate and the second wiring substrate; the connecting terminal on the back surface of the first wiring substrate and the connecting terminal on the front surface of the second wiring substrate may be electrically connected to each other via a conductive member that is formed to penetrate through the joining layer; and the joining layer may include a base material made of a thermosetting resin, and a joining material disposed on each of both surfaces of the base material, configured to join the first wiring substrate and the second wiring substrate to each other, and made of a thermoplastic resin.
   With the configuration, the joining layer includes the joining material formed on each of both the surfaces and made of the thermoplastic resin, and the base material disposed between the joining materials on both the surfaces. Since the base material is made of the thermosetting resin, the base material is less likely to be deformed even when heat for joining the first wiring layer and the second wiring layer to each other is applied to the joining layer. Thus, the first wiring substrate and the second wiring substrate are joined to each other in a state where the joining can be released by the joining materials, and also are electrically stably connected to each other by the base material 31 that is less likely to be deformed.
(3) In the multilayer wiring substrate of the above-described aspect, a thickness of one of the layers of the first wiring substrate may be smaller than a thickness of the joining layer in a stacking direction of the first wiring substrate, the joining layer, and the second wiring substrate.

With the configuration, the thickness of each layer of the first wiring substrate in the stacking direction is smaller than the thickness of the joining layer. Namely, with the configuration, the thickness of the first wiring substrate can be decreased. Thus, the number of wiring layers that constitute the first wiring substrate can be increased, and the wires of a circuit that is constituted by the wiring layers can be thinned.

The present invention can be implemented according to various aspects. For example, the present invention can be implemented according to aspects including a wiring substrate, a multilayer wiring substrate, a semiconductor wiring substrate, a component including any one of the substrates, and a method of manufacturing the wiring substrate or the multilayer wiring substrate.

### Brief Description of Drawings

[Fig. 1] Fig. 1 is a schematic cross-sectional view of a multilayer wiring substrate as an embodiment of the present invention.
[Fig. 2] Fig. 2 is an explanatory diagram of a cross section of a first wiring substrate.
[Fig. 3] Fig. 3 is a schematic cross-sectional view of a joining layer before the first wiring substrate and a second wiring substrate are joined to each other.
[Fig. 4] Fig. 4 is a flowchart of a method of manufacturing the multilayer wiring substrate.
[Fig. 5] Fig. 5 is an explanatory diagram of a method of manufacturing the joining layer.
[Fig. 6] Fig. 6 is an explanatory diagram of the method of manufacturing the joining layer.

### Description of Embodiments

### <Embodiment>

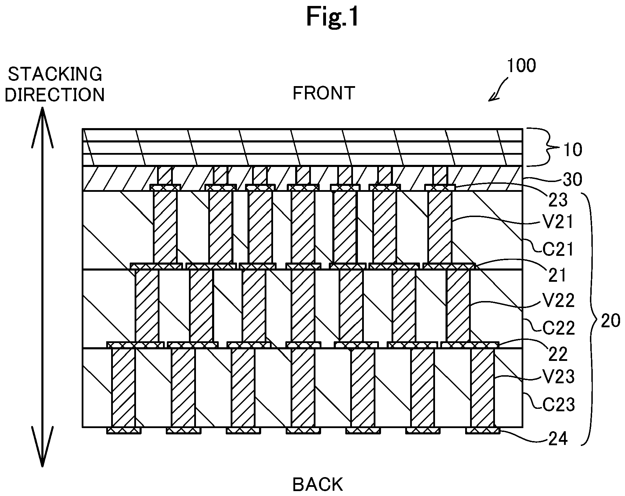

Fig. 1 is a schematic cross-sectional view of a multilayer wiring substrate 100 as an embodiment of the present invention. The multilayer wiring substrate 100 of the present embodiment is used as a probe card that is used for semiconductor inspection. The probe card is a tool for inspecting electric time characteristics of a plurality of electronic components formed on a silicon wafer. Fig. 1 illustrates an overview of a cross section in a stacking direction of respective layers that form the multilayer wiring substrate 100.

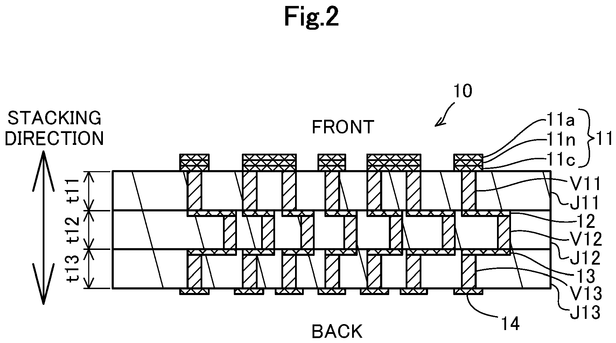

As illustrated in Fig. 1, the multilayer wiring substrate 100 includes a first wiring substrate 10 in which a plurality of resin layers made of a thermosetting resin are stacked, a second wiring substrate made of a ceramic, and a joining layer 30 disposed between a back surface of the first wiring substrate 10 and a front surface of the second wiring substrate 20. Note that Fig. 1 omits illustration for the details of the first wiring substrate 10, and the details of the first wiring substrate 10 will be described also with reference to Fig. 2.

As illustrated in Fig. 1, the second wiring substrate 20 is a substrate in which three ceramic layers C21 to C23 made of a ceramic are stacked. In the present embodiment, the three ceramic layers C21 to C23 are substrates made of aluminum oxide and having the same thickness. A connecting terminal 23 is formed on a front surface of the ceramic layer C21. Wiring layers 21 and 22 having predetermined patterns are formed on respective front surfaces of the ceramic layers C22 and C23. Also, a connecting terminal 24 is formed on a back surface of the ceramic layer C23. Namely, the connecting terminals 23 and 24 are formed on the front surface and a back surface of the second wiring substrate 20.

A via conductor V21 that electrically connects the connecting terminal 23 formed on the front surface of the ceramic layer C21 and the wiring layer 21 to each other is formed in the ceramic layer C21. Similarly, a via conductor V22 that electrically connects the wiring layer 21 and the wiring layer 22 to each other is formed in the ceramic layer C22. A via conductor V23 that connects the wiring layer 22 and the connecting terminal 24 formed on the back surface of the ceramic layer C23 to each other is formed in the ceramic layer C23. Each of the via conductors V21 to V23 are made of W (tungsten). The via conductors V21 to V23 electrically connect the connecting terminal 23 formed on the front surface of the second wiring substrate 20 and the connecting terminal 24 formed on the back surface of the second wiring substrate 20 to each other.

Fig. 2 is an explanatory diagram of a cross section of the wiring substrate 10. Fig. 2 presents a schematic diagram illustrating a cross section of the wiring substrate 10 in an enlarged manner only in the stacking direction. As illustrated in Fig. 2, the first wiring substrate 10 of the present embodiment is a substrate in which a plurality of resin layers J11 to J13 made of a polyimide that is a thermosetting resin are stacked. Wiring layers 12 and 13 having predetermined patterns are formed between the resin layers J11 to J13 in a state in contact with the resin layers J11 to J13. Also, a connecting terminal 11 is formed on a front surface of the ceramic layer J11. A connecting terminal 14 is formed on a back surface of the ceramic layer J13. Namely, the connecting terminals 11 and 14 are formed on a front surface and the back surface of the first wiring substrate 10. The connecting terminal 11 is a terminal in which a Cu (copper) layer 11c, an Ni (nickel) layer 11n, and an Au (gold) layer 11a are stacked in that order from the front surface of the resin layer J11. The wiring layers 12 and 13, and the connecting terminal 14 are made of Cu-Ti.

A via conductor V11 that electrically connects the connecting terminal 11 and the wiring layer 12 to each other is formed in the resin layer J11. Similarly, a via conductor V12 that electrically connects the wiring layer 12 and the wiring layer 13 to each other is formed in the resin layer J12. A via conductor V13 that electrically connects the wiring layer 13 and the connecting terminal 14 to each other is formed in the resin layer J13. Each of the via conductors V11 to V13 is made of Cu-Ti. The via conductors V11 to V13 electrically connect the connecting terminal 11 formed on the front surface of the first wiring substrate 10 and the connecting terminal 14 formed on the back surface of the first wiring substrate 10 to each other.

The first wiring substrate 10 of the present embodiment is manufactured by a buildup method of forming the wiring layer 13, the resin layer J12, the wiring layer 12, the resin layer J11, and the wiring layer 11 in that order on the resin layer J13, instead of being manufactured by preparing the resin layers J11 to J13 separately and then collectively stacking the resin layers J11 to J13. Thus, thicknesses t11 to t13 of the respective resin layers J11 to J13 of the present embodiment in the stacking direction are smaller than the thicknesses in the case where the resin layers J11 to J13 are separately prepared.

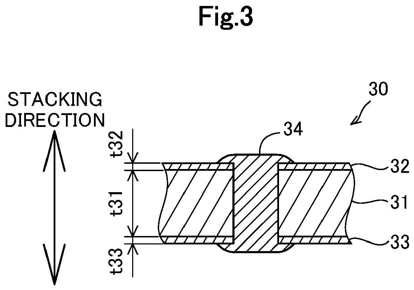

Fig. 3 is a schematic cross-sectional view of the joining layer 30 before the first wiring substrate 10 and the second wiring substrate 20 are joined to each other. Fig. 3 presents a cross-sectional view illustrating a portion of the joining layer 30 in an enlarged manner. As illustrated in Fig. 3, the joining layer 30 includes a base material 31 made of a polyimide that is a thermosetting resin, joining materials 32 and 33 disposed on both surfaces of the base material 31, and a conductive member 34. The joining materials 32 and 33 are made of a polyimide that is a thermoplastic resin and that is different from the polyimide of the base material 31.

In the present embodiment, the polyimide of the thermoplastic resin and the polyimide of the thermosetting resin are distinguished from each other based on a glass transition point. Specifically, a resin whose glass transition point is 300 degrees centigrade or higher is defined as a thermosetting resin, and a resin whose glass transition point is lower than 300 degrees centigrade is defined as a thermoplastic resin. The glass transition point can be specified by, for example, TMA method (Thermo Mechanical Analysis). In the present embodiment, the glass transition point of the polyimide of the thermoplastic resin is 240 degrees centigrade and the glass transition point of the polyimide of the thermosetting resin is 420 degrees centigrade.

The base material 31 with a thickness t31 of 10 to 100 µm in the stacking direction is used. In the present example, the thickness t31 is 30 µm. Also, the joining materials 32 and 33 with thicknesses t32 and t33 of 15 µm or less in the stacking direction can be used. In the present example, the thicknesses t32 and t33 are the same and are 3 µm. In the present embodiment, the thickness (t31 + t32 + t33) of the joining layer 30, which is the sum of the thicknesses of the base material 31 and the joining materials 32 and 33, is larger than the thickness of a layer (for example, J11) of the first wiring substrate 10. In other words, the thickness (for example, t11) of each layer of the first wiring substrate 10 in the stacking direction is smaller than the thickness of the joining layer 30.

The conductive member 34 is made of Ag. The conductive member 34 is formed to penetrate through the joining layer 30 (the base material 31 and the joining materials 32 and 33). As illustrated in Fig. 3, the conductive member 34 protrudes from a front surface and a back surface of the joining materials 32 and 33 in a thickness direction. As illustrated in Fig. 1, the conductive member 34 formed in and on the joining layer 30 is formed at each position at which the conductive member 34 connects the connecting terminal 14 formed on the back surface of the first wiring substrate 10 and the connecting terminal 23 formed on the front surface of the second wiring substrate 20 to each other. Namely, the conductive member 34 electrically connects the connecting terminal 14 on the back surface of the first wiring substrate 10 and the connecting terminal 23 on the front surface of the second wiring substrate 20 to each other.

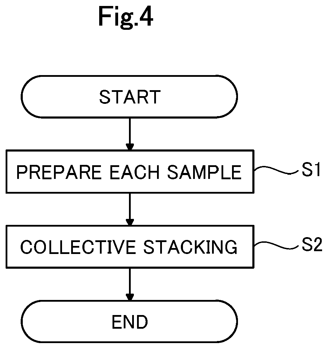

Fig. 4 is a flowchart of a method of manufacturing the multilayer wiring substrate 100. In the method of manufacturing the multilayer wiring substrate 100, first, the first wiring substrate 10, the second wiring substrate 20, and the joining layer 30 that are each a sample that constitutes the multilayer wiring substrate 100 are prepared (step S1). Then, in a state where the conductive member 34 of the joining layer 30 is disposed at the position at which the conductive member 34 connects the connecting terminal 14 of the first wiring substrate 10 and the connecting terminal 23 of the second wiring substrate 20 to each other, the first wiring substrate 10, the second wiring substrate 20, and the joining layer 30 are collectively stacked (step S2), thereby manufacturing the multilayer wiring substrate 100. Heat is applied to the joining layer 30 during the collective stacking. Thus, the joining materials 32 and 33 that are the thermoplastic resin of the joining layer 30 change to join the first wiring substrate 10 and the joining layer 30 to each other and to join the joining layer 30 and the second wiring substrate 20 to each other. As the result, the first wiring substrate 10 and the second wiring substrate 20 are joined to each other via the joining layer 30.

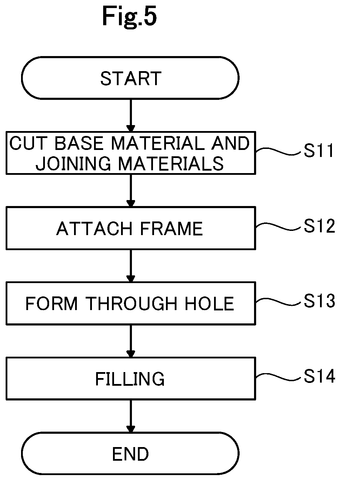

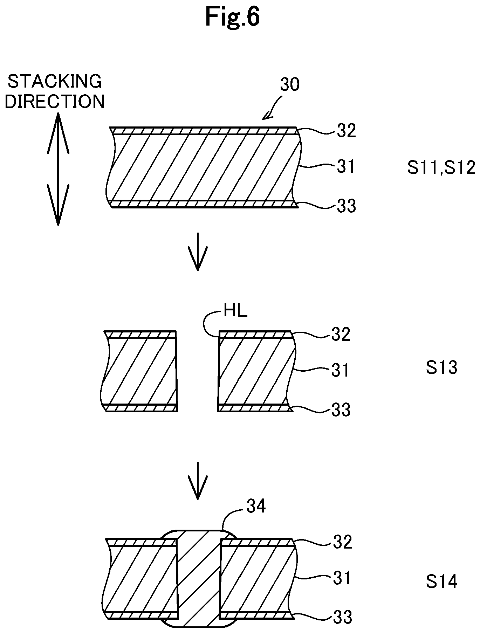

Fig. 5 and Fig. 6 are explanatory diagrams of a method of manufacturing the joining layer 30. Fig. 5 presents a flowchart of the method of manufacturing the joining layer 30. Fig. 6 presents a portion of a cross section of the joining layer 30 that changes according to the flowchart, to meet the respective steps presented in Fig. 5. In the method of manufacturing the joining layer 30, first, a sheet of the joining layer 30 having the joining materials 32 and 33 formed on both the surfaces of the base material 31 is cut into a predetermined size (step S11). A frame is attached to the cut joining layer 30 (step S12).

A through hole HL is formed by laser punching to extend through the joining layer 30 in the thickness direction (step S13). The formed through hole HL is filled with Ag that is to serve as the conductive member 34 (step S14), and the method of manufacturing the joining layer 30 is ended.

As described above, the multilayer wiring substrate 100 of the present embodiment includes the joining layer 30 that is disposed between the back surface of the first wiring substrate 10 having the wiring layers 12 and 13 and the front surface of the second wiring substrate 20 made of the ceramic and that joins the first wiring substrate 10 and the second wiring substrate 20 to each other. A surface of the joining layer 30 adjacent to the second wiring substrate 20 is formed of the joining material 33 of the thermoplastic resin. Namely, the first wiring substrate 10 and the second wiring substrate 20 are joined to each other by the thermoplastic resin that makes the joining material 33. Thus, when heat is applied to the multilayer wiring substrate 100, the thermoplastic resin changes, and the joining between the first wiring substrate 10 and the second wiring substrate 20 is released. In contrast, since the first wiring substrate 10 is formed of the plurality of layers made of the thermosetting resin, the joining between the respective layers is not released even when heat is applied. As the results, the completed multilayer wiring substrate 100 can be separated into the first wiring substrate 10 and the second wiring substrate 20, and the first wiring substrate 10 and the second wiring substrate 20 can be reused. Thus, reusing the second wiring substrate 20 that takes many man-hours for manufacturing can decrease the number of man-hours for manufacturing the multilayer wiring substrate 100. Also, fabricating in advance a ceramic commonly usable for many multilayer wiring substrates 100 decreases the number of man-hours for manufacturing the multilayer wiring substrate 100.

Also, as illustrated in Fig. 3, the joining layer 30 of the present embodiment includes the base material 31 made of the thermosetting resin, and the joining materials 32 and 33 of the thermoplastic resin disposed on both the surfaces of the base material 31. Moreover, the joining layer 30 has the conductive member 34 formed to penetrate through the joining layer 30 in the stacking direction. The conductive member 34 electrically connects the connecting terminal 14 on the back surface of the first wiring substrate 10 and the connecting terminal 23 on the front surface of the second wiring substrate 20 to each other. Since the base material 31 is made of the thermosetting resin, the base material 31 is less likely to be deformed compared with the joining materials 32 and 33 made of the thermoplastic resin. Thus, the first wiring substrate 10 and the second wiring substrate 20 are joined to each other in a state where the joining can be released by the joining materials 32 and 33, and also are electrically stably connected to each other by the base material 31 that is less likely to be deformed.

Also, the thickness of a layer (for example, the resin layer J11) of the first wiring substrate 10 of the present embodiment in the stacking direction is smaller than the thickness of the joining layer 30. Hence, the thickness of the entire first wiring substrate 10 can be decreased. Thus, the number of wiring layers that constitute the first wiring substrate 10 can be increased, and wires of a circuit that is constituted by the wiring layers can be thinned.

### <Modifications of Present Embodiment>

The present invention is not limited to the above-described embodiment, can be implemented in various embodiments within a range not departing from the gist of the invention, and can be modified, for example, as follows.

### [Modification 1]

In the above-described embodiment, the examples of the first wiring substrate 10, the second wiring substrate 20, and the joining layer 30 that constitute the multilayer wiring substrate 100 have been described. However, the respective configurations and respective shapes of the multilayer wiring substrate 100 can be modified in various ways. While the first wiring substrate 10 of the above-described embodiment is the multilayer body of the three resin layers J11 to J13 as illustrated in Fig. 2, the number of stacked layers may be two, or four or more. The thickness of each layer (for example, t11) in the stacking direction need not be smaller than the thickness of the joining layer 30. The layers may mixedly include a layer thinner than the joining layer 30 and a layer thicker than the joining layer 30. While the resin layers J11 to J13 of the above-described embodiment are made of the polyimide of the thermosetting resin, the resin layers J11 to J13 may be made of another thermosetting resin.

The predetermined patterns of the connecting terminals 11 and 14 and the wiring layers 12 and 13 can be modified. While the connecting terminal 11 formed on the front surface of the first wiring substrate 10 is the terminal in which the three metals of Au, Ni, and Cu are stacked, the connecting terminal 11 may be made of a kind of metal of the three metals, or may be made of another kind of metal (for example, Ag). The connecting terminal 14 can be omitted. For example, the via conductor V13 in the resin layer J13 may be directly connected to the conductive member 34 that penetrates through the joining layer 30. The via conductors V11 to V13 that respectively penetrate through the resin layers J11 to J13 may be made of a conductive material other than Cu or Ti (titanium), and may be made of, for example, Ag.

While the second wiring substrate 20 of the above-described embodiment is the multilayer body of the three ceramic layers C21 to C23 made of the ceramic as illustrated in Fig. 1, the second wiring substrate 20 may be a multilayer body including four or more layers, or, for example, may be formed of only one layer of the ceramic layer C21. The material that makes the ceramic layers C21 to C23 may be, for example, AlN (aluminum nitride), glass-ceramic, mullite, or BN, as a ceramic other than aluminum oxide. Also, the layers may be made of ceramics different from one another. The thicknesses of the respective ceramic layers C21 to C23 in the stacking direction need not be the same and may differ from one another. The predetermined patterns of the wiring layers 21 and 23 and the connecting terminals 23 and 24 can be modified. The via conductors V21 to 23 that respectively penetrate through the ceramic layers C21 to C23 may be made of a conductive material other than W, for example, Mo (molybdenum), a mixed material of Mo and W, or Cu.

While the joining layer 30 of the above-described embodiment is the layer in which the base material 31 serves as a parent material and the joining materials 32 and 33 of the thermoplastic resin are formed on both the surfaces of the base material 31, the configuration of the joining layer 30 can be modified in various ways. For example, only at least the joining material 33 on the back surface of the joining layer 30 adjacent to the second wiring substrate 20 may be made of a thermoplastic resin, and the joining material 32 on the front surface may be omitted. Also, the entire joining layer 30 may be made of a thermoplastic resin, and the joining layer 30 need not contain a thermosetting resin. The respective thicknesses t31 to t33 of the base material 31 and the joining materials 32 and 33 according to the above-described embodiment are merely examples, and may have other dimensions. The conductive member 34 may be made of a material other than Ag. For example, the conductive member 34 may be made of Cu, W, Mo, or Ta (tantalum).

Examples of the thermoplastic resin that is used for the joining layer 30 include acrylonitrile butadiene styrene copolymer synthetic resin (ABS resin), nylon, polypropylene (PP), polycarbonate (PC), polyamide (PA) nylon, polyacetal (POM), polybutylene terephthalate (PBT), polyetherimide (PEI), polyphenylene sulfide (PPS), polyetheretherketone (PEEK), liquid crystal polymer (LCP), polyphthalamide (PPA), polysulfone (PSU), polyethersulfone (PES), and polyamidoimide (PAI).

Examples of the thermosetting resin that is used for the base material 31 of the joining layer 30 include epoxy resin, phenolic resin, urea, melamine, unsaturated polyester, polyurethane, diallyphthalate, silicone, and alkyd.

The present aspect has been described above based on the embodiment and the modifications; however, the embodiment of the above-described aspect is provided for easier understanding of the present aspect, and is not for limiting the present aspect. The present aspect may be changed and improved without departing from the gist of the aspect and the claims, and the present aspect also includes equivalents to the aspect. Also, the technical features of the aspect may be appropriately deleted unless otherwise the technical features are described as being essential in the specification.

### Reference Signs List

10 first wiring substrate
11, 14 connecting terminal
11a Au layer
11c Cu layer
11n Ni layer
12, 13 wiring layer
20 second wiring substrate
21, 22 wiring layer
23, 24 connecting terminal
30 joining layer
31 base material
32, 33 joining material
34 conductive member
100 multilayer wiring substrate
C21 to C23 ceramic layer
HL through hole
J11, J12, J13 resin layer
V11 to V13 via conductor
V21 to V23 via conductor
t11 to t13, t31 to t33 thickness

## Claims

1. A multilayer wiring substrate comprising:
a first wiring substrate including a plurality of stacked layers made of a thermosetting resin and having a wiring layer formed between each adjacent layers of the layers in a state in contact with the adjacent layers;
a second wiring substrate made of a ceramic; and
a joining layer disposed between a back surface of the first wiring substrate and a front surface of the second wiring substrate and configured to join the first wiring substrate and the second wiring substrate to each other,
wherein at least a surface of the joining layer adjacent to the second wiring substrate is made of a thermoplastic resin.

2. The multilayer wiring substrate in accordance with claim 1,
wherein a connecting terminal is formed on each of front surfaces and back surfaces of the first wiring substrate and the second wiring substrate,
wherein the connecting terminal on the back surface of the first wiring substrate and the connecting terminal on the front surface of the second wiring substrate are electrically connected to each other via a conductive member that is formed to penetrate through the joining layer, and
wherein the joining layer includes
a base material made of a thermosetting resin, and
a joining material disposed on each of both surfaces of the base material, configured to join the first wiring substrate and the second wiring substrate to each other, and made of a thermoplastic resin.

3. The multilayer wiring substrate in accordance with claim 1 or claim 2,
wherein a thickness of one of the layers of the first wiring substrate is smaller than a thickness of the joining layer in a stacking direction of the first wiring substrate, the joining layer, and the second wiring substrate.
